# EUROPÄISCHE PATENTSCHRIFT

(11) **EP 2 465 148 B1**
(45) Veröffentlichungstag und Bekanntmachung des Hinweises auf die Patenterteilung: **09.08.2017**
(21) Anmeldenummer: 10726134.9
(22) Anmeldetag: 30.06.2010
(51) Int. Cl.: H01L 33/32, H01L 33/06

(54) **ELEKTRISCH GEPUMPTER OPTOELEKTRONISCHER HALBLEITERCHIP**
ELECTRICALLY PUMPED OPTOELECTRONIC SEMICONDUCTOR CHIP
PUCE SEMI-CONDUCTRICE OPTOÉLECTRONIQUE POMPÉE ÉLECTRIQUEMENT

(30) Priorität: 13.08.2009 DE 102009037416
(43) Veröffentlichungstag der Anmeldung: 20.06.2012
(73) Patentinhaber: OSRAM Opto Semiconductors GmbH, 93055 Regensburg (DE)
(72) Erfinder: PETER, Matthias, 93055 Regensburg (DE); MEYER, Tobias, 93346 Ihrlerstein (DE); OFF, Jürgen, 93059 Regensburg (DE); TAKI, Tetsuya, 223-0057 Yokohama (JP); HERTKORN, Joachim, 93087 Alteglofsheim (DE); SABATHIL, Matthias, 93059 Regensburg (DE); LAUBSCH, Ansgar, 93055 Regensburg (DE); BIEBERSDORF, Andreas, 93055 Regensburg (DE)
(74) Vertreter: Epping - Hermann - Fischer
(86) Internationale Anmeldenummer: PCT/EP2010/059291
(87) Internationale Veröffentlichungsnummer: WO 2011/018273

(56) Entgegenhaltungen:
- EP-A1- 1 667 292
- EP-A1- 1 883 141
- JP-A- 2001 168 471
- US-A1- 2002 053 676
- US-A1- 2002 195 606
- US-A1- 2004 135 136
- US-A1- 2006 108 603
- US-A1- 2008 247 435
- CHANG S J ET AL: "400nm InGaN/GaN and InGaN/AlGaN multiquantum well light-emitting diodes" IEEE JOURNAL OF SELECTED TOPICS IN QUANTUM ELECTRONICS, Bd. 8, Nr. 4, Juli 2002 (2002-07), Seiten 744-748, XP002602363

## Beschreibung

Es wird ein elektrisch gepumpter optoelektronischer Halbleiterchip angegeben.

Es offenbart die Druckschrift JP 2001-168471 A ein lichtemittierendes Element, basierend auf einem Nitrid-Halbleitermaterial. Diese Druckschrift gibt eine aktive Zone mit einer Multiquantentopfstruktur an, bei der jeweils ein Quantentopf, der zur Lichtemission dient, von einer Deckschicht und einer Barriereschicht gefolgt wird. Aus der Druckschrift US 2002/0195606 A1 ist eine LED aus einem III-Nitrid bekannt, die eine undotierte Mantelschicht und eine Multiquantentopfstruktur aufweist.

Ein Nitrid-basiertes, optoelektronisches Halbleiterbauteil ist in der Druckschrift US 2002/0053676 A1 angegeben.

Die Druckschrift US 6,849,881 B1 betrifft ein optoelektronisches Halbleiterbauteil mit einer Multi-Quantentrogstruktur.

In der Druckschrift US 2002/0179923 A1 ist eine Leuchtdiode angegeben.

Eine LD oder LED mit einer Übergitter-Mantelschicht findet sich in der Druckschrift EP 1 883 141 A1.

Die Beschreibung eines auf GaN basierenden, Licht emittierenden Bauteils ist in der Druckschrift EP 1 667 292 A1 enthalten.

In der Druckschrift US 2006/0108603 A1 ist ein Strahlung emittierendes III-Nitrid-Halbleiterbauteil offenbart.

Eine Halbleiterlaserdiode mit einer Zwischenschicht ist in der Druckschrift US 2008/0247435 A1 wiedergegeben.

Es beschäftigt sich die Druckschrift US 2004/0135136 A1 mit einem Licht emittierenden Halbleiterbauteil.

Der Artikel S. J. Chang et al. "400-nm InGaN-GaN and InGaN-AlGaN Multiquantum Well Light-Emitting Diodes" in IEEE

Der Artikel S. J. Chang et al. "400-nm InGaN-GaN and InGaN-AlGaN Multiquantum Well Light-Emitting Diodes" in IEEE

Journal of Selected Topics in Quantum Electronics, Vol. 8, No. 4, Seiten 744 bis 748, aus dem Jahr 2002 befasst sich mit LEDs.

Eine zu lösende Aufgabe besteht darin, einen elektrisch gepumpten optoelektronischen Halbleiterchip anzugeben, der bei kleinen Stromdichten eine hohe Effizienz aufzeigt.

Diese Aufgabe wird gelöst durch einen optoelektronischen Halbleiterchip mit den Merkmalen des Anspruchs 1, durch den die Erfindung definiert wird. Gemäß zumindest einer Ausführungsform des optoelektronischen Halbleiterchips weist dieser mindestens zwei strahlungsaktive Quantentröge auf. Strahlungsaktiv bedeutet, dass im Betrieb des Halbleiterchips in diesen Quantentrögen eine elektromagnetische Strahlung erzeugt wird. Beispielsweise wird in jedem der strahlungsaktiven Quantentröge ein Leistungsanteil, bezogen auf die gesamte vom Halbleiterchip erzeugte Strahlung, von mindestens 2,5 %, insbesondere von mindestens 4,0 % erzeugt. Eine Wellenlänge der Strahlung kann im ultravioletten und/oder sichtbaren Spektralbereich liegen, bevorzugt bei Wellenlängen zwischen einschließlich 420 nm und 480 nm.

Die Bezeichnung Quantentrog entfaltet keine Bedeutung hinsichtlich einer Dimensionalität der Quantisierung. Der Begriff Quantentrog umfasst somit zum Beispiel mehrdimensionale Quantentöpfe, eindimensionale Quantendrähte und als nulldimensional anzusehende Quantenpunkte sowie jede Kombination dieser Strukturen.

Gemäß zumindest einer Ausführungsform des optoelektronischen Halbleiterchips ist dieser elektrisch gepumpt. Das heißt, an einer elektrischen p-Anschlussseite und an einer elektrischen n-Anschlussseite des Halbeiterchips werden je positive beziehungsweise negative Ladungsträger injiziert, die im bestimmungsgemäßen Betrieb des Halbleiterchips jeweils hin zur anderen Anschlussseite propagieren. Bei dieser Propagation durch den Halbleiterchip gelangen die Ladungsträger wenigstens teilweise in die strahlungsaktiven Quantentröge, worin die positiven mit den negativen Ladungsträger mindestens zum Teil rekombinieren. Mittels dieser Ladungsträgerrekombination wird die vom Halbleiterchip emittierte Strahlung erzeugt.

Gemäß zumindest einer Ausführungsform des optoelektronischen Halbleiterchips umfassen die strahlungsaktiven Quantentröge InGaN oder bestehen hieraus.

Gemäß zumindest einer Ausführungsform des optoelektronischen Halbleiterchips beinhaltet dieser mindestens zwei Deckschichten, die AlGaN umfassen oder hieraus bestehen. Jede der Deckschichten ist bevorzugt genau einem der strahlungsaktiven Quantentröge zugeordnet. Insbesondere kann zwischen den Deckschichten und den strahlungsaktiven Quantentrögen eine eineindeutige Zuordnung vorliegen.

Dass die strahlungsaktiven Quantentröge aus InGaN und die Deckschichten AlGaN umfassen kann bedeuten, dass die Quantentröge sowie die Deckschichten nur aus den angegebenen Atomen bestehen und eine Beimengung von Fremdatomen, beispielsweise in Form einer Dotierung, beinhalten. Ein Anteil aller Fremdatome zusammengenommen an den strahlungsaktiven Quantentrögen sowie an den Deckschichten beträgt bevorzugt jeweils höchstens 1 Atom-%, insbesondere höchstens 0,1 Atom-%, bevorzugt höchstens 0,01 Atom-%.

Gemäß zumindest einer Ausführungsform des optoelektronischen Halbleiterchips befinden sich die Deckschichten je an einer p-Seite der strahlungsaktiven Quantentröge. Dass sich die Deckschichten an der p-Seite befinden, bedeutet, dass die Deckschicht in einer Hauptpropagationsrichtung von positiven Ladungsträgern im Betrieb des Halbleiterchips dem zugeordneten strahlungsaktiven Quantentrog vorgeordnet ist. Mit anderen Worten durchlaufen positive Ladungsträger, insbesondere so genannte Löcher, im bestimmungsgemäßen Betrieb des Halbleiterchips zuerst die Deckschicht und anschließend den der Deckschicht zugeordneten strahlungsaktiven Quantentrog.

Gemäß zumindest einer Ausführungsform des optoelektronischen Halbleiterchips beträgt ein Abstand zwischen den strahlungsaktiven Quantentrögen und den jeweils zugeordneten Deckschichten höchstens 1,5 nm, insbesondere höchstens 1,0 nm, bevorzugt höchstens 0,5 nm. Das heißt, die Deckschichten befinden sich in unmittelbarer Nähe zu den strahlungsaktiven Quantentrögen.

In mindestens einer Ausführungsform des elektrisch gepumpten optoelektronischen Halbleiterchips weist dieser mindestens zwei strahlungsaktive Quantentröge auf, wobei die strahlungsaktiven Quantentröge InGaN umfassen oder hieraus bestehen. Weiterhin beinhaltet der optoelektronische Halbleiterchip zumindest zwei Deckschichten, die AlGaN umfassen oder hieraus bestehen. Jede der Deckschichten ist genau einem der strahlungsaktiven Quantentröge zugeordnet. Die Deckschichten befinden sich je an einer p-Seite des zugeordneten strahlungsaktiven Quantentrogs. Ein Abstand zwischen dem strahlungsaktiven Quantentrog und der zugeordneten Deckschicht beträgt höchstens 1,5 nm.

Durch die Verwendung einer Mehrzahl von Quantentrögen kann eine effektive Ladungsträgerdichte pro strahlungsaktivem Quantentrog im Betrieb des Halbleiterchips reduziert werden. Die Reduzierung dieser Ladungsträgerdichte kann wiederum zu einer Erhöhung der internen und der externen Quanteneffizienz führen, gerechnet jeweils auf einen der strahlungsaktiven Quantentröge. Damit geht auch eine Steigerung der vom Halbleiterchip emittierten Helligkeit einher, ebenso wie eine Absenkung einer Flussspannung.

Werden, wie angegeben, Deckschichten aus AlGaN verwendet und an den InGaN-Quantentrögen aufgebracht, so werden aufgrund von Grenzladungseffekten wie Piezofeldern die Strukturen des Leitungsbandes und des Valenzbandes des Halbleitermaterials verbogen. Durch diese Verbiegung des Leitungsbandes und des Valenzbandes erfahren negative Ladungsträger, insbesondere Elektronen, eine höhere Barriere. Dahingegen ist eine Leitung von positiven Ladungsträgern, insbesondere von so genannten Löchern, begünstigt. Aufgrund der verbesserten Beweglichkeit der positiven Ladungsträger ist eine effektive Erhöhung eines Wellenfunktionsüberlapps der Wellenfunktionen der positiven und negativen Ladungsträger in dem strahlungsaktiven Quantentrog realisierbar.

Durch den erhöhten Wellenfunktionsüberlapp kann eine Rekombinationsrate der positiven und der negativen Ladungsträger ansteigen. Dies kann außerdem zu einer Verbesserung eines Kleinstromverhaltens und einer Hochtemperaturstabilität des Halbleiterchips führen, zum Beispiel bei Temperaturen oberhalb von oder bei zirka 120 °C.

Mit anderen Worten wird bei kleinen Stromdichten und bei hohen Temperaturen mit höherer Quantenausbeute Licht emittiert. Außerdem kann eine erhöhte Beweglichkeit der positiven Ladungsträger dazu führen, dass mehr Quantentröge strahlungsaktiv sind und weiterhin dass aufgrund der reduzierten Ladungsträgerdichte pro Quantentrog die Flussspannung abgesenkt werden kann.

Eine weitere Möglichkeit zur Erhöhung einer Temperaturstabilität des Halbleiterchips besteht darin, weniger und vergleichsweise dünne Quantentröge zu formen. Allerdings kann dies mit einer Verringerung der Effizienz bei Raumtemperatur einhergehen.

Gemäß zumindest einer Ausführungsform des optoelektronischen Halbleiterchips ist der Halbleiterchip durch ein epitaktisches Wachsen hergestellt.

Gemäß zumindest einer Ausführungsform des optoelektronischen Halbleiterchips beträgt ein Aluminiumgehalt der Deckschichten zwischen einschließlich 20 % und 70 %. Mit anderen Worten sind 20 % bis 70 % der Galliumgitterplätze von GaN durch Aluminiumatome besetzt.

Gemäß zumindest einer Ausführungsform des optoelektronischen Halbleiterchips weisen die Deckschichten eine Dicke oder eine mittlere Dicke zwischen einschließlich 0,3 nm und 1,5 nm auf, insbesondere zwischen einschließlich 0,5 nm und 1,0 nm. Gemäß zumindest einer Ausführungsform des optoelektronischen Halbleiterchips umfasst dieser mindestens zwei Zwischenschichten. Die Zwischenschichten bestehen aus GaN oder umfassen dieses. Dass die Zwischenschichten GaN umfassen kann bedeuten, dass Fremdatome mit einer Konzentration von weniger als 1 Atom-%, insbesondere von weniger als 0,1 Atom-%, bevorzugt von weniger als 0,01 Atom-% in der Zwischenschicht vorliegen.

Gemäß zumindest einer Ausführungsform des optoelektronischen Halbleiterchips befindet sich je eine der Zwischenschichten zwischen je einer der Deckschichten und dem der Deckschicht zugeordneten strahlungsaktiven Quantentrog. Die Zwischenschicht steht hierbei bevorzugt in unmittelbarem Kontakt sowohl zu dem strahlungsaktiven Quantentrog als auch zu der zugeordneten Deckschicht.

Gemäß zumindest einer Ausführungsform des optoelektronischen Halbleiterchips beträgt eine Dicke der Zwischenschichten jeweils zwischen einschließlich 0,3 nm und 1,2 nm, insbesondere zwischen einschließlich 0,4 nm und 0,8 nm. Sind die Zwischenschichten derart gestaltet, so beträgt ein Aluminiumgehalt der Deckschichten bevorzugt zwischen einschließlich 40 % und 70 %.

Gemäß zumindest einer Ausführungsform des optoelektronischen Halbleiterchips weist ein Übergangsbereich zwischen den strahlungsaktiven Quantentrögen, den Deckschichten und/oder den Zwischenschichten eine Dicke zwischen einschließlich einer Monolage und drei Monolagen auf. Eine Monolage ist hierbei eine einzelne, dicht gepackte Lage aus Atomen. Eine Dicke der Monolage entspricht somit in etwa einem mittleren Atomdurchmesser der Atome der Monolage. Im Falle von GaN beträgt eine Dicke der Monolage zirka 0,3 nm bis 0,4 nm.

In dem Übergangsbereich ändert sich eine stöchiometrische Zusammensetzung einer der Monolagen zum Beispiel von den strahlungsaktiven Quantentrögen hin zu einer stöchiometrischen Zusammensetzung etwa der Deckschicht. Mit anderen Worten liegt in dem Übergangsbereich innerhalb einer Monolage beispielsweise sowohl InGaN als auch AlGaN lokal begrenzt innerhalb einer einzigen Monolage vor. Die Monolagen weisen dabei eine Haupterstreckungsrichtung senkrecht zu einer Wachstumsrichtung des Halbleiterchips auf.

Gemäß zumindest einer Ausführungsform des optoelektronischen Halbleiterchips beträgt ein Abstand zwischen den strahlungsaktiven Quantentrögen und den jeweils zugeordneten Deckschichten höchstens zwei Monolagen. Mit anderen Worten liegen zwischen einer Monolage des Quantentrogs, die im Rahmen der Herstellungstoleranzen insbesondere nur InGaN aufweist, und zwischen einer Monolage der Deckschicht, die im Rahmen der Herstellungstoleranzen insbesondere lediglich AlGaN umfasst, lediglich höchstens zwei Monolagen mit einer Mischung aus InGaN, GaN und/oder AlGaN. In dieser Ausführungsform beträgt der Aluminiumgehalt der Deckschicht bevorzugt zwischen einschließlich 20 % und 50 %.

Gemäß zumindest einer Ausführungsform des optoelektronischen Halbleiterchips umfasst dieser zwischen einschließlich drei strahlungsaktiven Quantentrögen und 20 strahlungsaktiven Quantentrögen, insbesondere zwischen einschließlich fünf strahlungsaktiven Quantentrögen und 15 strahlungsaktiven Quantentrögen. Es ist hierbei möglich, dass der Halbleiterchip eine größere Anzahl an Quantentrögen umfasst, beispielsweise mehr als 30 Quantentröge, wobei dann lediglich ein Teil der Quantentröge im Betrieb des Halbleiterchips strahlungsaktiv ist. Mit anderen Worten kann dann der Halbleiterchip sowohl strahlungsaktive Quantentröge als auch strahlungsinaktive Quantentröge umfassen.

Gemäß zumindest einer Ausführungsform des optoelektronischen Halbleiterchips beträgt ein Abstand zwischen zwei in Wachstumsrichtung aufeinander folgenden Deckschichten zwischen einschließlich 3 nm und 8 nm, insbesondere zwischen einschließlich 4 nm und 6 nm.

Gemäß zumindest einer Ausführungsform des optoelektronischen Halbleiterchips beträgt eine Bandlücke der strahlungsaktiven Quantentröge je zwischen einschließlich 2,55 eV und 3,0 eV. Bei einer Bandlücke der strahlungsaktiven Quantentröge in diesem Wertebereich ist eine Steigerung der Beweglichkeit der positiven Ladungsträger durch die aus AlGaN bestehende oder dieses umfassende Deckschicht besonders effizient.

Gemäß zumindest einer Ausführungsform des optoelektronischen Halbleiterchips ist eine mittlere Bandlücke der Zwischenschicht um mindestens 20 % gegenüber einer mittleren Bandlücke des zugeordneten strahlungsaktiven Quantentrogs erhöht. Mit anderen Worten beträgt die mittlere Bandlücke im Bereich der Zwischenschicht mindestens 120 %, insbesondere mindestens 130 % der Bandlücke, wie sie gemittelt über dem Bereich des zugeordneten strahlungsaktiven Quantentrogs vorliegt.

Gemäß zumindest einer Ausführungsform des optoelektronischen Halbleiterchips ist eine mittlere Bandlücke in einem Bereich außerhalb des strahlungsaktiven Quantentrogs, der unmittelbar an die p-Seite des Quantentrogs grenzt, größer als in einem entsprechenden Bereich an einer n-Seite des strahlungsaktiven Quantentrogs. Die n-Seite ist hierbei einer n-Anschlussseite des Halbleiterchips zugewandt. Die Bereiche außerhalb des strahlungsaktiven Quantentrogs an der p-Seite und an der n-Seite weisen bevorzugt eine Breite zwischen einschließlich 0,4 nm und 1,0 nm, insbesondere 0,6 nm, auf. Außerdem beträgt die mittlere Bandlücke des Bereichs an der p-Seite bevorzugt mindestens 105 %, insbesondere mindestens 110 % der mittleren Bandlücke des Bereichs an der n-Seite.

Gemäß zumindest einer Ausführungsform des optoelektronischen Halbleiterchips weisen zwei benachbarte strahlungsaktive Quantentröge eine voneinander abweichende mittlere Bandlücke auf. Mit anderen Worten sind die benachbarten strahlungsaktiven Quantentröge dazu eingerichtet, im Betrieb des Halbleiterchips Strahlungen mit unterschiedlichen Wellenlängen zu emittieren.

Gemäß zumindest einer Ausführungsform des optoelektronischen Halbleiterchips beträgt die Abweichung der mittleren Bandlücke zwischen den benachbarten Quantentrögen zwischen einschließlich 0,03 eV und 0,20 eV, insbesondere zwischen einschließlich 0,05 eV und 0,18 eV.

Gemäß zumindest einer Ausführungsform des optoelektronischen Halbleiterchips umfasst dieser mindestens eine Barriereschicht, die zwischen zwei benachbarten strahlungsaktiven Quantentrögen angeordnet ist. Bevorzugt umfasst die Barriereschicht GaN oder besteht hieraus. Insbesondere grenzt die Barriereschicht unmittelbar an eine der Deckschichten und an einen der Deckschicht nicht zugeordneten strahlungsaktiven Quantentrog.

Nachfolgend wird ein hier beschriebener optoelektronischer Halbleiterchip unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

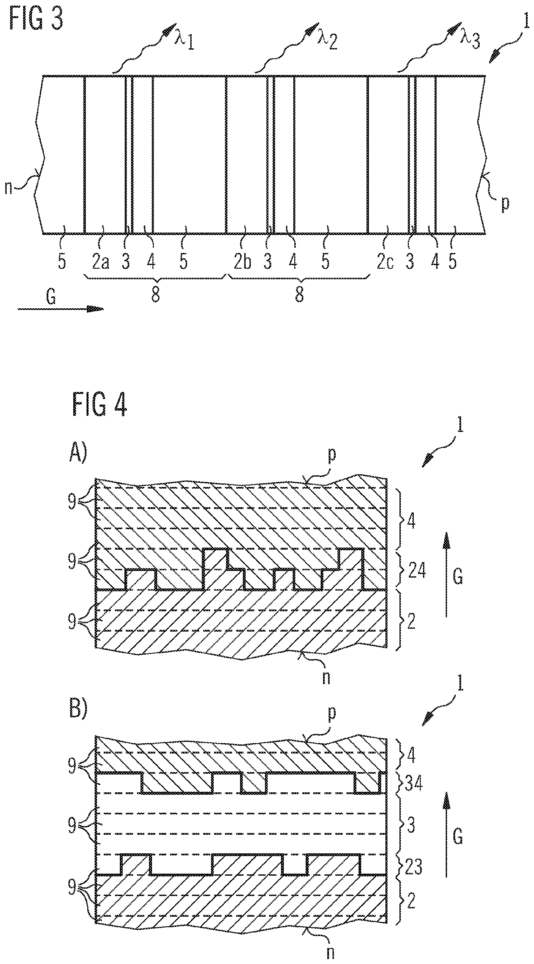

- Figuren 3 und 4: schematische Darstellungen von Ausführungsbeispielen von hier beschriebenen optoelektronischen Halbleiterchips, und
- Figuren 1 und 2: schematische Darstellungen von Abwandlungen des Halbleiterchips.

In Figur 1A ist eine Abwandlung eines elektrisch gepumpten Halbleiterchips 1 als schematische Schnittdarstellung illustriert. Der Halbleiterchip 1, der bevorzugt epitaktisch gewachsen ist,
weist eine p-Anschlussseite p und eine n-Anschlussseite n auf. Im bestimmungsgemäßen Betrieb des Halbleiterchips 1 wird an der p-Anschlussseite p eine positive Spannung und an der n-Anschlussseite n eine relativ zur p-Anschlussseite p negative Spannung angelegt. Negative Ladungsträger wie Elektronen bewegen sich im Betrieb des Halbleiterchips 1 von der n-Anschlussseite n hin zur p-Anschlussseite p, positive Ladungsträger wie Löcher bewegen sich von der p-Anschlussseite p hin zur n-Anschlussseite n. Die Ladungsträger werden jeweils über die Anschlussseiten p, n in den Halbleiterchip 1 injiziert.

Der Halbleiterchip 1 weist mehrere strahlungsaktive Quantentröge 2 auf. Im Betrieb des Halbleiterchips 1 wird in den strahlungsaktiven Quantentrögen 2 eine elektromagnetische Strahlung durch Rekombination der Ladungsträger erzeugt. In einer Richtung hin zur p-Anschlussseite p, beispielsweise also in einer Wachstumsrichtung G, ist den strahlungsaktiven Quantentrögen 2 jeweils eine Deckschicht 4 nachgeordnet. Die Deckschicht 4 weist eine Dicke T zwischen einschließlich 0,3 nm und 0,5 nm auf, bevorzugt zirka 0,5 nm. Die Deckschicht 4 besteht im Wesentlichen aus AlGaN, wobei die Deckschicht 4 eine Dotierung in Form von Fremdatomen umfassen kann. Ein Anteil der Fremdatome an der Deckschicht 4 beträgt hierbei bevorzugt höchstens 0,01 Atom-%.

Eine Dicke Q der strahlungsaktiven Quantentröge 2 beträgt zum Beispiel zwischen einschließlich 1,5 nm und 4,5 nm, insbesondere zirka 3,5 nm. Die Quantentröge 2 bestehen hierbei aus InGaN. Ein Indiumgehalt beträgt bevorzugt zwischen einschließlich 15 % und 35 %. Mit anderen Worten ist ein Anteil von 15 % bis einschließlich 35 % der Galliumgitterplätze durch Indiumatome belegt.

Entlang der Wachstumsrichtung G befindet sich zwischen den Deckschichten 4 und den strahlungsaktiven Quantentrögen 2 jeweils eine Barriereschicht 5. Die Barriereschicht 5 besteht bevorzugt aus GaN. Auch die Barriereschichten 5 können eine Dotierung mit Fremdatomen aufweisen.

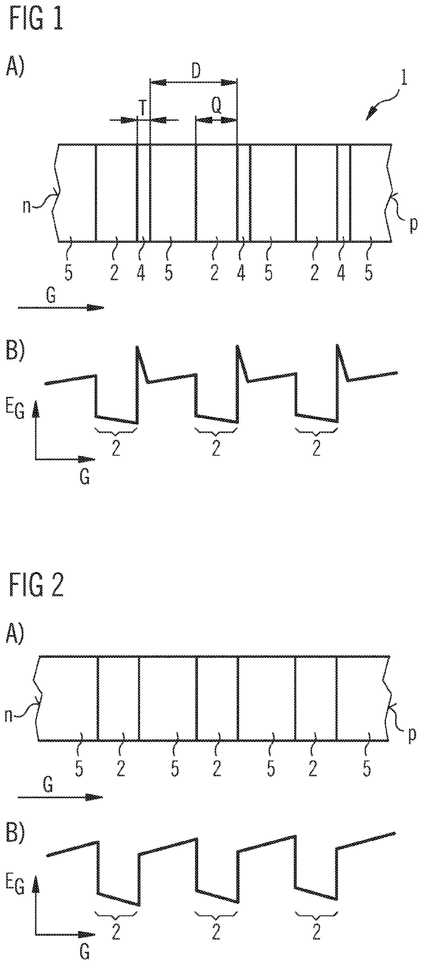

Ein Abstand zwischen zwei benachbarten Deckschichten 4 liegt bevorzugt zwischen einschließlich 3 nm und 8 nm, insbesondere bei zirka 6 nm. Ein Aluminiumgehalt der Deckschichten 4 beträgt bei Ausführungsbeispiel gemäß der Figur 1A beispielsweise zwischen einschließlich 20 % und 50 %.

In Figur 1B ist schematisch ein Verlauf einer Bandlücke EG entlang der Wachstumsrichtung G illustriert. Im Bereich der strahlungsaktiven Quantentröge 2 beträgt die Bandlücke E_{G} beispielsweise zirka 2,55 eV. Im Bereich der Deckschichten 4 übersteigt die Bandlücke E_{G} bevorzugt zirka 3,4 eV. Durch die Deckschichten 4 erfolgt also eine lokale Erhöhung der Bandlücke E_{G} und eine Art Verzerrung einer Struktur des Valenzbandes und des Leitungsbandes an der p-Anschlussseite p zugewandten p-Seiten der strahlungsaktiven Quantentröge 2. Die Bandlücke E_{G} außerhalb der strahlungsaktiven Quantentröge 2 an den p-Seiten übersteigt die Bandlücke E_{G} außerhalb der strahlungsaktiven Quantentröge 2 an n-Seiten, die der n-Anschlussseite n zugewandt sind. Durch diese Verformung der Bandlückenstruktur ist eine Beweglichkeit der Löcher erhöht.

Hierdurch ist erzielbar, dass insbesondere alle strahlungsaktiven Quantentröge 2 zur Emission einer Strahlung beitragen. Derjenige der Quantentröge 2, der sich am nächsten zur p-Anschlussseite p befindet, emittiert dabei anteilig am meisten Strahlung, wohingegen derjenige Quantentrog 2, der sich am nächsten zur n-Anschlussseite n befindet, anteilig am wenigsten Strahlung emittiert. Jeder der strahlungsaktiven Quantentröge 2 emittiert bevorzugt mindestens 2,5 % eine vom Halbleiterchip 1 generierten Gesamtstrahlungsleistung.

In Figur 2 ist ein herkömmliches optoelektronisches Halbleiterbauteil dargestellt, siehe die Schnittdarstellung in Figur 2A und die Bandlückenstruktur in Figur 2B. Das Halbleiterbauteil weist, in Wachstumsrichtung G gesehen, eine Abfolge zwischen den Barriereschichten 5 und den Quantentrögen 2 auf. Da insbesondere die Deckschichten 4 bei dem Halbleiterbauteil gemäß Figur 2 fehlen, ist es möglich, dass nur einer der Quantentröge 2 zu einer Emission von Strahlung beiträgt.

Die Struktur der Bandlücke E_{G} weist keine Erhöhung der Bandlücke an den p-Seiten der Quantentröge 2 auf. Im Gegenteil ist die Bandlücke E_{G} an den p-Seiten gegenüber n-Seiten der Quantentröge 2 sogar erniedrigt.

Beim Ausführungsbeispiel des Halbleiterchips 1 gemäß Figur 3 befindet sich zwischen den strahlungsaktiven Quantentrögen 2a-c und den jeweils zugeordneten Deckschichten 4 je eine Zwischenschicht 3. Die Zwischenschicht 3 besteht aus GaN und kann ebenso wie die Quantentröge 2, die Deckschichten 4 und die Barriereschichten 5 eine Dotierung von Fremdatomen aufweisen. Eine Dicke der Zwischenschicht 3 ist bevorzugt kleiner als 1 nm. Insbesondere beträgt die Dicke zirka 0,5 nm. Der Aluminiumgehalt der Deckschichten 4 liegt bei dem Halbleiterchip 1 gemäß Figur 3 bevorzugt zwischen einschließlich 40 % und 70 %.

Der Halbleiterchip 1 weist bevorzugt zwischen einschließlich drei Schichtenabfolgen 8 und 20 Schichtenabfolgen 8 auf. Die Schichtenabfolgen 8 grenzen jeweils unmittelbar aneinander, ohne weitere Zwischenlagen. Jede der Schichtenabfolgen 8 besteht aus einem der strahlungsaktiven Quantentröge 2a-c, einer der Zwischenschichten 3, einer der Deckschichten 4 und einer der Barriereschichten 5. Die genannten Schichten folgen in der genannten Reihenfolge unmittelbar aufeinander, ohne dass weitere Zwischenlagen vorliegen.

Es ist ebenso wie in allen anderen Ausführungsbeispielen möglich, dass die strahlungsaktiven Quantentrögen 2a-c im Betrieb des Halbleiterchips 1 jeweils Strahlungen mit voneinander verschiedenen Wellenlängen λ₁, λ₂, λ₃ erzeugen. Beispielsweise liegt die Wellenlänge λ₁ bei zirka 440 nm, die Wellenlänge λ₂ bei zirka 450 nm und die Wellenlänge λ₃ bei zirka 465 nm. Unter Wellenlänge ist hierbei jeweils insbesondere diejenige Wellenlänge zu verstehen, bei der im Betrieb des Halbleiterchips 1 eine maximale spektrale Leistungsdichte emittiert wird.

In Figur 4A ist eine schematische Schnittdarstellung eines weiteren Ausführungsbeispiels des Halbleiterchips 1 dargestellt, der zum Beispiel analog zu Figur 1 aufgebaut sein kann. In Figur 4B ist eine Detailansicht des Halbleiterchips 1 insbesondere analog zu Figur 3 illustriert.

Die Halbleiterchips 1 weisen eine Folge von Monolagen 9 entlang der Wachstumsrichtung G auf. Die Monolagen 9 erstrecken sich in eine Richtung senkrecht zur Wachstumsrichtung G und weisen eine Dicke von jeweils einem mittleren Atomdurchmesser der sich in den jeweiligen Monolagen 9 befindlichen Atome auf. In den Figuren 4A und 4B sind die Monolagen 9 durch Bereiche des Halbleiterchips 1 symbolisiert, die durch Strichlinien voneinander abgegrenzt sind.

Zwischen dem strahlungsaktiven Quantentrog 2 und der Deckschicht 4 befindet sich ein Übergangsbereich 24, siehe Figur 4A. In dem Übergangsbereich 24 gibt es Unterbereiche, in denen eine Materialzusammensetzung der des strahlungsaktiven Quantentrogs 2 entspricht. Ebenso existieren andere Unterbereiche, in denen die Materialzusammensetzung der der Deckschicht 4 entspricht. Gemäß Figur 4A beträgt eine Dicke des Übergangsbereichs 24 zwei Monolagen.

Beim Ausführungsbeispiel gemäß der Figur 4B weisen die Übergangsbereiche 23, 24 zwischen dem strahlungsaktiven Quantentrog 2 und der Zwischenschicht 3 sowie zwischen dem strahlungsaktiven Quantentrog 2 und der Deckschicht 4 jeweils eine Dicke von einer einzigen Monolage auf. Anders als in den Figuren 4A und 4B dargestellt, können die Übergangsbereiche 23, 24, 34 eine bevorzugte Dicke zwischen einschließlich einer Monolage und drei Monolagen aufzeigen. Die Dicke der Übergangsbereiche 23, 24, 34 ist zum Beispiel über Transmissionselektronenmikroskopie, kurz TEM, messbar.

Wie auch in allen Ausführungsbeispielen ist es möglich, dass der Halbleiterchip 1 eine oder mehrere weitere, in den Figuren nicht dargestellte Schichten umfasst. Solche Schichten können Tunnelschichten oder Tunnelübergänge, Ladungsträgersperrschichten, strahlungsinaktive Quantentröge, elektrische Kontaktschichten, Mantelschichten und/oder optische Wellenleiterschichten sein. Ebenso können die strahlungsaktiven Quantentröge 2 jeweils entlang der Wachstumsrichtung G einen variierenden Indiumgehalt aufweisen. So ist es möglich, dass die strahlungsaktiven Quantentröge 2 mehrere nicht dargestellte Teilschichten umfassen, die sich in ihrem Indiumgehalt voneinander unterscheiden.

Ein Nachweis der Anzahl der strahlungsaktiven Quantentröge 2 ist zum Beispiel darüber möglich, eine Wellenlängenverschiebung der vom Halbleiterchip 1 emittierten Strahlung gegenüber einer Stromstärke, mit der der Halbleiterchip 1 bestromt wird, zu ermitteln. Je größer eine Verschiebung der Wellenlänge ist, desto geringer ist die Anzahl an strahlungsaktiven Quantentrögen. Ebenso kann über eine Bestimmung der internen Quanteneffizienz der strahlungsaktiven Quantentröge gegenüber einer Stromstärke, mit der der Halbleiterchip 1 betrieben wird, die Anzahl der strahlungsaktiven Quantentröge ermittelt werden.

## Patentansprüche

1. Elektrisch gepumpter optoelektronischer Halbleiterchip (1) mit
- mindestens zwei strahlungsaktiven Quantentrögen (2), die InGaN umfassen oder hieraus bestehen, und
- mindestens zwei Deckschichten (4), die AlGaN umfassen oder hieraus bestehen,
wobei
- jede der Deckschichten (4) genau einem der strahlungsaktiven Quantentröge (2) zugeordnet ist,
- sich die Deckschichten (4) je an einer p-Seite der strahlungsaktiven Quantentröge (2) befinden, und
- ein Abstand zwischen den strahlungsaktiven Quantentrögen (2) und den zugeordneten Deckschichten (4) höchstens 1,5 nm beträgt,
- sich eine Schichtenabfolge (8) zwischen einschließlich dreimal und zwanzigmal wiederholt,
- benachbarte Schichtenabfolgen (8) unmittelbar aufeinander folgen,
- die Schichtenabfolge (8) aus den unmittelbar in der aufgelisteten Reihenfolge aufeinander folgenden Schichten besteht:
- dem strahlungsaktiven Quantentrog (2),
- einer Zwischenschicht (3) mit oder aus GaN,
- der Deckschicht (4), und
- einer Barriereschicht (5), die GaN umfasst oder hieraus besteht,
wobei ferner
- eine mittlere Dicke der Deckschichten (4) zwischen einschließlich 0,3 nm und 1,5 nm liegt und die Zwischenschichten (3) eine Dicke zwischen einschließlich 0,3 nm und 1,2 nm aufweisen und ein Abstand zwischen zwei in Wachstumsrichtung aufeinander folgenden Deckschichten (4) zwischen einschließlich 3 nm und 8 nm beträgt,
- eine mittlere Bandlücke der Zwischenschichten (4) je mindestens 120 % einer mittleren Bandlücke des zugeordneten strahlungsaktiven Quantentrogs (2) beträgt,
- eine mittlere Bandlücke in einem Bereich außerhalb der strahlungsaktiven Quantentröge (2), welcher jeweils unmittelbar an die p-Seite des zugehörigen Quantentrogs (2) grenzt, größer ist als in einem entsprechenden Bereich an einer n-Seite des entsprechenden strahlungsaktiven Quantentrogs (2), und
- durch die Deckschichten (4) die Strukturen des Leitungsbandes und des Valenzbandes eines Halbleitermaterials des Halbleiterchips (1) verbogen werden, sodass negative Ladungsträger eine höhere Barriere erfahren, wohingegen eine Leitung von positiven Ladungsträgern begünstigt ist.

2. Optoelektronischer Halbleiterchip (1) nach dem vorhergehenden Anspruch, bei dem die Zwischenschichten (3) eine Dicke zwischen einschließlich 0,4 nm und 0,8 nm aufweisen und ein Abstand zwischen zwei in Wachstumsrichtung aufeinander folgenden Deckschichten (4) zwischen einschließlich 4 nm und 6 nm beträgt.

3. Optoelektronischer Halbleiterchip (1) nach einem der vorhergehenden Ansprüche,
bei dem ein Al-Gehalt der Deckschichten (4) zwischen einschließlich 20 % und 70 % liegt.

4. Optoelektronischer Halbleiterchip (1) nach zumindest Anspruch 2,
bei dem eine Dicke oder eine mittlere Dicke der Deckschichten (4) zwischen einschließlich 0,5 nm und 1,0 nm liegt.

5. Optoelektronischer Halbleiterchip (1) nach einem der vorhergehenden Ansprüche,
bei dem eine Dicke (Q) der strahlungsaktiven Quantentröge (2) zwischen einschließlich 1,5 nm und 4,5 nm beträgt,
wobei ein Indiumgehalt der aus InGaN bestehenden Quantentröge (2) zwischen einschließlich 15 % und 35 % beträgt.

6. Optoelektronischer Halbleiterchip (1) nach dem vorhergehenden Anspruch,
bei dem die Zwischenschichten (3) eine Dicke zwischen einschließlich 0,3 nm und 1,2 nm aufweisen und bei dem ein Al-Gehalt der Deckschichten (4) zwischen einschließlich 40 % und 70 % beträgt.

7. Optoelektronischer Halbleiterchip (1) nach einem der Ansprüche 1 bis 5,
bei dem der Abstand zwischen den strahlungsaktiven Quantentrögen (2) und den jeweils zugeordneten Deckschichten (4) höchstens zwei Monolagen beträgt und bei dem ein Al-Gehalt der Deckschichten (4) zwischen einschließlich 20 % und 50 % beträgt.

8. Optoelektronischer Halbleiterchip (1) nach einem der vorhergehenden Ansprüche,
bei dem ein Übergangsbereich (23, 24, 34) zwischen den strahlungsaktiven Quantentrögen (2), den Deckschichten (4) und/oder den Zwischenschichten (3) eine Dicke zwischen einschließlich einer und drei Monolagen aufweist.

9. Optoelektronischer Halbleiterchip (1) nach einem der vorhergehenden Ansprüche,
der zwischen einschließlich 5 und 15 strahlungsaktive Quantentröge (2) umfasst.

10. Optoelektronischer Halbleiterchip (1) nach mindestens Anspruch 7, bei dem die strahlungsaktiven Quantentröge (2) nur InGaN aufweisen,
wobei sich zwischen einer Monolage der Deckschicht (4), die lediglich AlGaN umfasst, höchstens zwei Monolagen mit einer Mischung aus InGaN, GaN und/oder AlGaN befinden.

11. Optoelektronischer Halbleiterchip (1) nach einem der vorhergehenden Ansprüche,
bei dem eine Bandlücke der strahlungsaktiven Quantentröge (2) je zwischen einschließlich 2,55 eV und 3,0 eV beträgt.

12. Optoelektronischer Halbleiterchip (1) nach einem der vorhergehenden Ansprüche,
bei dem zumindest zwei benachbarte strahlungsaktive Quantentröge (2) eine voneinander abweichende mittlere Bandlücke aufzeigen, wobei die Abweichung zwischen einschließlich 0,03 eV und 0,20 eV beträgt.

## Claims

1. Electrically pumped optoelectronic semiconductor chip (1) having
- at least two radiation-active quantum wells (2), which comprise InGaN or consist thereof, and
- at least two cover layers (4), which comprise AlGaN or consist thereof,
wherein
- each of the cover layers (4) is assigned to precisely one of the radiation-active quantum wells (2),
- the cover layers (4) are each located on a p-side of the radiation-active quantum wells (2), and
- the distance between the radiation-active quantum wells (2) and the associated cover layers (4) amounts to at most 1.5 nm,
- a layer sequence (8) is repeated between three times and twenty times inclusive,
- adjacent layer sequences (8) succeed one another directly,
- the layer sequence (8) consists of layers succeeding one another directly in the order listed:
- the radiation-active quantum well (2),
- an interlayer (3) with or of GaN,
- the cover layer (4) and
- a barrier layer (5), which comprises GaN or consists thereof,
wherein furthermore
- the average thickness of the cover layers (4) is between 0.3 nm and 1.5 nm inclusive and the interlayers (3) have a thickness of between 0.3 nm and 1.2 nm inclusive and the distance between two cover layers (4) succeeding one another in the direction of growth amounts to between 3 nm and 8 nm inclusive,
- the average band gap of the interlayers (4) amounts in each case to at least 120 % of the average band gap of the associated radiation-active quantum well (2),
- the average band gap in a region outside the radiation-active quantum wells (2), which in each case directly adjoins the p-side of the associated quantum well (2), is greater than in a corresponding region on an n-side of the corresponding radiation-active quantum well (2), and
- as a result of the cover layers (4), the structures of the conduction band and of the valence band of a semiconductor material of the semiconductor chip (1) are deformed, such that negative charge carriers experience a higher barrier whereas the conduction of positive charge carriers is promoted.

2. Optoelectronic semiconductor chip (1) according to the preceding claim, in which the interlayers (3) have a thickness of between 0.4 nm and 0.8 nm inclusive and the distance between two cover layers (4) succeeding one another in the direction of growth amounts to between 4 nm and 6 nm inclusive.

3. Optoelectronic semiconductor chip (1) according to one of the preceding claims,
in which the Al content of the cover layers (4) is between 20 % and 70 % inclusive.

4. Optoelectronic semiconductor chip (1) according to at least claim 2,
in which the thickness or the average thickness of the cover layers (4) is between 0.5 nm and 1.0 nm inclusive.

5. Optoelectronic semiconductor chip (1) according to one of the preceding claims,
in which the thickness (Q) of the radiation-active quantum wells (2) amounts to between 1.5 nm and 4.5 nm inclusive,
wherein the indium content of the quantum wells (2) consisting of InGaN amounts to between 15 % and 35 % inclusive.

6. Optoelectronic semiconductor chip (1) according to the preceding claim,
in which the interlayers (3) have a thickness of between 0.3 nm and 1.2 nm inclusive and in which the Al content of the cover layers (4) amounts to between 40 % and 70 % inclusive.

7. Optoelectronic semiconductor chip (1) according to one of claims 1 to 5,
in which the distance between the radiation-active quantum wells (2) and the in each case associated cover layers (4) amounts to at most two monolayers and in which the Al content of the cover layers (4) amounts to between 20 % and 50 % inclusive.

8. Optoelectronic semiconductor chip (1) according to one of the preceding claims,
in which a transition region (23, 24, 34) between the radiation-active quantum wells (2), the cover layers (4) and/or the interlayers (3) has a thickness of between one and three monolayers inclusive.

9. Optoelectronic semiconductor chip (1) according to one of the preceding claims,
which comprises between 5 and 15 radiation-active quantum wells (2) inclusive.

10. Optoelectronic semiconductor chip (1) according to at least claim 7, in which the radiation-active quantum wells (2) only comprise InGaN,
wherein at most two monolayers comprising a mixture of InGaN, GaN and/or AlGaN are located between a monolayer of the cover layer (4) which comprises only AlGaN.

11. Optoelectronic semiconductor chip (1) according to one of the preceding claims,
in which the band gap of the radiation-active quantum wells (2) amounts in each case to between 2.55 eV and 3.0 eV inclusive.

12. Optoelectronic semiconductor chip (1) according to one of the preceding claims,
in which at least two adjacent radiation-active quantum wells (2) exhibit different average band gaps, wherein the difference amounts to between 0.03 eV and 0.20 eV inclusive.

## Revendications

1. Puce à semi-conducteur optoélectronique pompée électriquement
(1) avec
- au moins deux puits quantiques radioactifs (2), qui englobent du InGaN ou en sont composés, et
- au moins deux couches de protection (4), qui englobent du AlGaN ou en sont composées,
dans laquelle
- chacune des couches de protection (4) est précisément affectée à un puits quantique radioactif (2),
- les couches de protection (4) se trouvent chacune sur un côté p du puits quantique radioactif (2), et
- un écartement entre les puits quantiques radioactifs (2) et les couches de protection affectées (4) s'élève au maximum à 1,5 nm,
- une suite de couches (8) se répète entre y compris trois et vingt fois,
- les suites de couches voisines (8) se succèdent immédiatement,
- la suite de couches (8) se compose des couches immédiatement successives suivantes :
- le puits quantique radioactif (2),
- une couche intermédiaire (3) avec du GaN ou en GaN,
- la couche de protection (4), et
- une couche barrière (5), qui englobe du GaN ou en est composée,
dans laquelle en outre
- une épaisseur moyenne des couches de protection (4) se situe entre y compris 0,3 nm et 1,5 nm et les couches intermédiaires (3) présentent une épaisseur entre y compris 0,3 nm et 1,2 nm et un écartement entre deux couches de protection consécutives (4) dans le sens croissant se situe entre y compris 3 nm et 8 nm,
- une bande interdite moyenne des couches intermédiaires (4) correspond au moins à 120 % d'une bande interdite moyenne du puits quantique radioactif affecté (2),
- une bande interdite moyenne est, dans une zone en dehors du puits quantique radioactif (2), laquelle est respectivement directement contiguë au côté p du puits quantique (2) correspondant, plus grande que dans une zone correspondante sur un côté n du puits quantique radioactif (2) correspondant, et
- les couches de protection (4) dissimulent les structures de la bande de conduction et de la bande de valence d'un matériau semi-conducteur de la puce à semi-conducteur (1), de sorte que les porteurs de charge négatifs sont soumis à une barrière plus importante, une conduction des porteurs de charge positifs étant par contre favorisée.

2. Puce à semi-conducteur optoélectronique (1) selon la revendication précédente,
dans laquelle les couches intermédiaires (3) présentent une épaisseur entre y compris 0,4 nm et 0,8 nm et un écartement entre deux couches de protection (4) successives dans le sens croissant se situe entre y compris 4 nm et 6 nm.

3. Puce à semi-conducteur optoélectronique (1) selon l'une des revendications précédentes,
dans laquelle une teneur en Al des couches de protection (4) se situe entre y compris 20 % et 70 %.

4. Puce à semi-conducteur optoélectronique (1) au moins selon la revendication 2,
dans laquelle une épaisseur ou une épaisseur moyenne des couches de protection (4) se situe entre y compris 0,5 nm et 1,0 nm.

5. Puce à semi-conducteur optoélectronique (1) selon l'une des revendications précédentes,
dans laquelle une épaisseur (Q) du puits quantique radioactif (2) se situe entre y compris 1,5 nm et 4,5 nm,
dans laquelle une teneur en indium du puits quantique (2) en InGaN se situe entre y compris 15 % et 35 %.

6. Puce à semi-conducteur optoélectronique (1) selon la revendication précédente,
dans laquelle les couches intermédiaires (3) présentent une épaisseur entre y compris 0,3 nm et 1,2 nm et dans laquelle une teneur en Al des couches de protection (4) se situe entre y compris 40 % et 70 %.

7. Puce à semi-conducteur optoélectronique (1) selon l'une des revendications 1 à 5,
dans laquelle l'écartement entre les puits quantiques radioactifs (2) et les couches de protection respectives affectées (4) correspond au maximum à deux monocouches et dans laquelle une teneur en Al des couches de protection (4) se situe entre y compris 20 % et 50 %.

8. Puce à semi-conducteur optoélectronique (1) selon l'une des revendications précédentes,
dans laquelle une zone transitoire (23, 24, 34) entre les puits quantiques radioactifs (2), les couches de protection (4) et/ou les couches intermédiaires (3) présente une épaisseur entre y compris une et trois monocouches.

9. Puce à semi-conducteur optoélectronique (1) selon l'une des revendications précédentes,
englobant entre y compris 5 et 15 puits quantiques radioactifs (2).

10. Puce à semi-conducteur optoélectronique (1) selon au moins la revendication 7, dans laquelle les puits quantiques radioactifs (2) présentent uniquement du InGaN, maximum deux monocouches avec un mélange de InGaN, GaN et/ou AlGaN se trouvant entre une monocouche de la couche de protection (4) englobant uniquement du AlGaN.

11. Puce à semi-conducteur optoélectronique (1) selon l'une des revendications précédentes,
dans laquelle une bande interdite du puits quantique radioactif (2) se situe respectivement entre y compris 2,55 eV et 3,0 eV.

12. Puce à semi-conducteur optoélectronique (1) selon l'une des revendications précédentes,
dans laquelle au moins deux puits quantiques radioactifs voisins (2) présentent une bande interdite moyenne différente, dans laquelle la différence se situe entre y compris 0,03 eV et 0,20 eV.
